Europäisches Patentamt

European Patent Office

Office européen des brevets

(11) Numéro de publication: **0 453 040 A1**

# DEMANDE DE BREVET EUROPEEN

(21) Numéro de dépôt: **91200885.1**

(22) Date de dépôt: **15.04.91**

(51) Int. Cl.5: **H03K 17/66, H03K 19/00, H03F 3/30**

(30) Priorité: **19.04.90 FR 9005010**

(43) Date de publication de la demande:
**23.10.91 Bulletin 91/43**

(84) Etats contractants désignés:
**DE FR GB IT**

(71) Demandeur: **PHILIPS COMPOSANTS**
**117, quai du Président Roosevelt**
**F-92130 Issy les Moulineaux(FR)**
(84) **FR**

Demandeur: **N.V. Philips'**
**Gloeilampenfabrieken**

**Groenewoudseweg 1**
**NL-5621 BA Eindhoven(NL)**
(84) **DE GB IT**

(72) Inventeur: **Barbu, Stéphane, Société Civile**
**S.P.I.D.**
**156, Boulevard Haussmann**
**F-75008 Paris(FR)**

(74) Mandataire: **Jacquard, Philippe et al**
**Société Civile S.P.I.D. 156, Boulevard**
**Haussmann**
**F-75008 Paris(FR)**

(54) **Amplificateur de puissance notamment pour signaux carres.**

(57) L'invention concerne une cellule d'amplificateur de puissance comprenant un amplificateur inverseur d'entrée comportant un premier transistor ($T_1$) ayant un collecteur relié à une première source de tension d'alimentation à travers une première résistance ($R_{11}$), ainsi qu'un étage de sortie présentant un deuxième ($T_4$) et un troisième ($T_6$) transistor ayant des trajets collecteur-émetteur en série, leur point commun constituant une sortie (5) de l'amplificateur de puissance, la base du deuxième transistor ($T_4$) étant connectée au collecteur du premier transistor ($T_1$), et des moyens pour appliquer à la base du troisième transistor ($T_6$) un signal de commande.

Une telle cellule comporte un premier condensateur ($C_1$) disposé en parallèle avec la première résistance ($R_{11}$), le signal de commande est le signal d'entrée (E) ou une partie fractionnaire de celui-ci et lesdits moyens consistent en une deuxième résistance ($R_{16}$) disposée en série dans la base du troisième transistor ($T_6$). Un amplificateur de puissance peut comporter deux cellules dont les premiers transistors ($T_1$) sont couplés par les émetteurs.

FIG. 2

EP 0 453 040 A1

La présente invention concerne une cellule d'amplificateur de puissance comprenant un amplificateur inverseur d'entrée comportant un premier transistor ayant un collecteur relié à une première source de tension d'alimentation à travers une première résistance, ainsi qu'un étage de sortie présentant un deuxième et un troisième transistor ayant des trajets collecteur-émetteur en série, leur point commun constituant une sortie de l'amplificateur de puissance, la base du deuxième transistor étant connectée au collecteur du premier transistor, et des moyens pour appliquer à la base du troisième transistor un signal de commande en phase avec un signal d'entrée appliqué à la base du premier transistor.

Un tel amplificateur est connu du brevet US 3 564 281 (fig.7b) concernant un inverseur logique rapide ainsi que de l'article "A Wide-Band Class AB Monolithic Power Amplifier" de Robert G. MEYER et William D. MACK paru dans IEEE Journal of Solid State Circuits vol. 24 n° 1 février 1989.

Le brevet Us 3 564 281 décrit un circuit logique fonctionnant en commutation mais qui n'est pas un amplificateur. L'amplificateur décrit dans l'article précité est conçu pour fonctionner en signaux sinusoïdaux et avec une charge essentiellement résistive.

L'invention a pour objet une cellule d'amplificateur de puissance pouvant fonctionner avec des signaux d'entrée carrés (par exemple des signaux d'horloge) et avec une impédance capacitive. Ces deux contraintes qui ne sont rencontrées que séparément dans les deux documents précités sont particulièrement sévères car elles impliquent des commutations rapides de courants de valeur relativement élevée.

L'idée de base de l'invention consiste à réaliser la fonction recherchée tout en maintenant un chemin minimal pour les signaux. Pour ce faire, la commutation est accélérée dans l'amplificateur inverseur d'entrée de manière à optimiser le temps de montée dans la branche comportant en série l'amplificateur inverseur d'entrée et le deuxième transistor, et le troisième transistor est alimenté directement à partir du signal d'entrée, son temps de commutation étant ajusté de manière à correspondre à celui de ladite branche.

Une cellule d'amplificateur de puissance selon l'invention est caractérisée en ce qu'elle comporte un premier condensateur disposé en parallèle avec la première résistance, en ce que le signal de commande est le signal d'entrée à un coefficient multiplicatif près inférieur ou égal à 1 et en ce que lesdits moyens consistent en une deuxième résistance disposée en série dans la base du troisième transistor.

Le deuxième transistor et la première source de tension permettent respectivement la charge et la décharge de l'impédance capacitive. Le premier condensateur permet de manière surprenante d'accroître la vitesse de commutation du premier transistor, et la deuxième résistance permet d'ajuster le temps de commutation du troisième transistor de manière à synchroniser la commutation des deuxième et troisième transistors.

La cellule peut comporter un diviseur de tension agencé de manière à recevoir le signal d'une source d'entrée et à générer le signal d'entrée et le signal de commande. Ceci permet d'ajuster les amplitudes des signaux sur les bases des permier et troisième transistors, en particulier pour éviter une commutation complète desdits transistors, d'où dans ce dernier cas gain en vitesse de réponse.

La cellule peut comporter un réseau parallèle résistance-condensateur disposé dans l'émetteur du troisième transistor et dont la constante de temps est de préférence égale au produit de la valeur de la première résistance et du premier condensateur.

L'invention concerne également un amplificateur différentiel de puissance comportant deux cellules d'amplificateur telles que définis ci-dessus, les premiers transistors de chaque cellule étant couplés entre eux par les émetteurs.

Selon un mode de réalisation avantageux, les troisièmes transistors présentent une troisième résistance connectées entre leurs émetteurs. Ceci présente l'avantage de permettre de régler la plage de linéarité de l'étage différentiel comportant les troisièmes transistors. Une première et une deuxième source de courant peuvent être connectées aux émetteurs respectifs des troisièmes transistors de chaque cellule.

Selon une variante, une quatrième et une cinquième résistance sont connectées en série entre les émetteurs des troisième transistors, et une troisième source de courant (faisant fonction desdites première et deuxième sources de courant) est connectée au point commun à la quatrième et à la cinquième résistance.

Un troisième condensateur peut être connecté entre les émetteurs des troisièmes transistors.

Ce condensateur est vu comme une inductance dans les collecteurs des troisièmes transistors, d'où augmentation de la bande passante.

Selon un mode de réalisation préféré, une sixième et une septième résistance peuvent être disposées en série respectivement entre les trajets collecteur-émetteur des deuxième et troisième transistors de chaque cellule. Elles permettent un découplage entre les collecteurs des troisièmes transistors et la charge capacitive des sorties de manière à éviter les ondulations sur les transistoires.

Une huitième résistance peut être connectée entre les bases des premiers transistors de chaque cellule.

Au cas où un décalage de niveau de tension est souhaitable, un transistor monté en diode est connecté en direct entre un point commun aux premières résistances des deux cellules et la première source de tension d'alimentation, un quatrième condensateur pouvant alors être connecté entre ledit point commun et la deuxième source de tension d'alimentation. Le quatrième condensateur créé un point de masse virtuel et élimine les effets de mode commun tout en compensant l'effet selfique produit par les diodes.

L'invention sera mieux comprise à la lecture de la description qui va suivre, donnée à titre d'exemple non limitatif, en liaison avec les dessins qui représentent :

- les figures 1a et 1b, un amplificateur de classe AB selon l'art antérieur précité,
- la figure 2, une cellule d'amplificateur de puissance selon l'invention,
- la figure 3, un amplificateur de puissance selon l'invention,
- la figure 4 un amplificateur de puissance selon un mode de réalisation préféré de l'invention, et la figure 5 une variante de l'étage différentiel de commutation en sortie.
- les figures 6a et 6b les signaux de commutation sur l'émetteur de $T_4$ via $T_1$, respectivement sans et avec le condensateur $C_1$.
- les figures 7a et 7b les signaux de commutation sur l'émetteur de $T_4$ (croisement), respectivement sans et avec le condensateur $C'_6$.

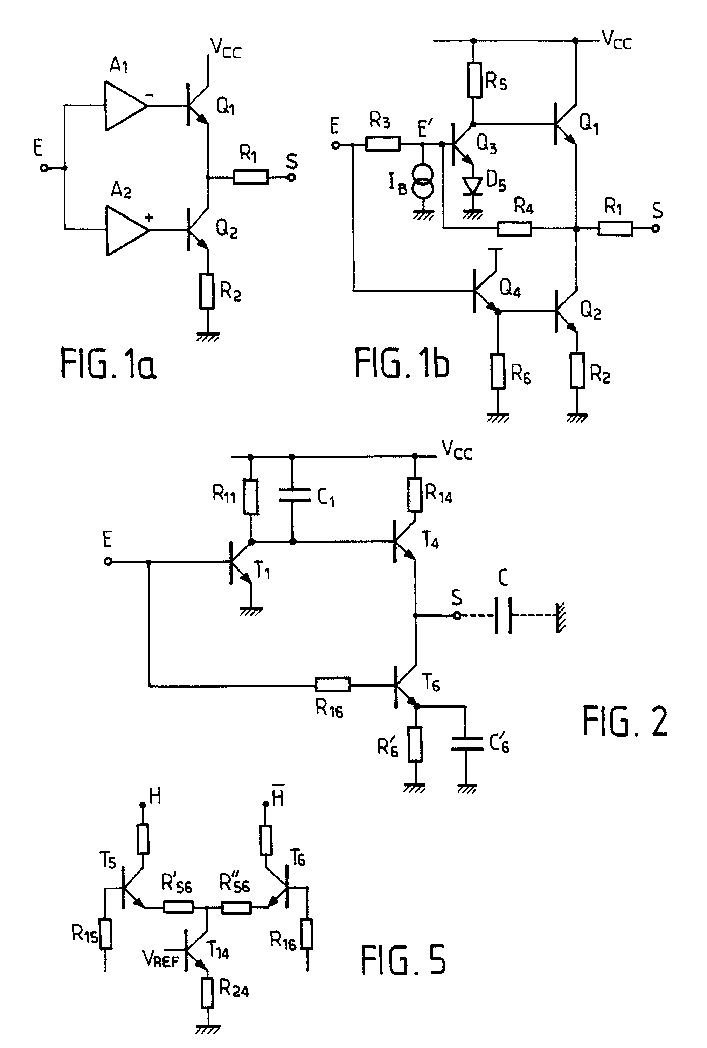

Selon la figure 1a, un amplificateur selon l'art antérieur est une variante du circuit dit "totem pole" tel que décrit par exemple dans l'ouvrage de P.R. GRAY et R.G. MEYER "Analysis and Design of Analog Integrated Circuits" $2^e$ ed. John Wiley New York 1984. Un transistor $Q_1$ dont la base est connectée à la sortie d'un inverseur $A_1$ dont l'entrée reçoit un signal d'entrée E active une sortie S à travers une résistance de sortie $R_1$. Pour les signaux de sortie S d'amplitude positive, un transistor $Q_2$ dont la base est connecté à la sortie d'un amplificateur non inverseur $A_2$ dont l'entrée reçoit le signal d'entrée E, est complètement à l'état bloqué. Pour des amplitudes négatives en sortie, le transistor $Q_2$ est débloqué pour permettre le passage du courant, sans toutefois que le transistor $Q_1$ soit bloqué, ce qui permet de maintenir la fonction de transfert. ($Q_1$ fonctionne à un niveau de courant réduit).

Un mode de réalisation de l'amplificateur de la figure 1a est montré à la figure 1b. L'amplificateur $A_1$ présente un transistor $Q_3$ dont la base est pourvue d'une résistance d'entrée $R_3$ et dont le collecteur est connecté à la base du transistor $Q_1$. Une résistance de contre-réaction $R_4$ est disposée

entre l'émetteur du transistor $Q_1$ et la base du transistor $Q_3$.

Une diode $D_5$ disposée en direct dans l'émetteur du transistor $Q_3$ décale la polarisation de ce transistor d'une tension base-émetteur $V_{be}$ et permet à l'émetteur suiveur (transistor $Q_4$) constituant l'amplificateur $A_2$ de fonctionner pour des tensions S négatives. Une source de courant de polarisation $I_B$ connectée à la base de $Q_3$ détermine la tension de polarisation sur l'émetteur de $Q_1$.

Le module représenté à la figure 2 est également du type "totem pole", mais avec des conditions de fonctionnement différentes.

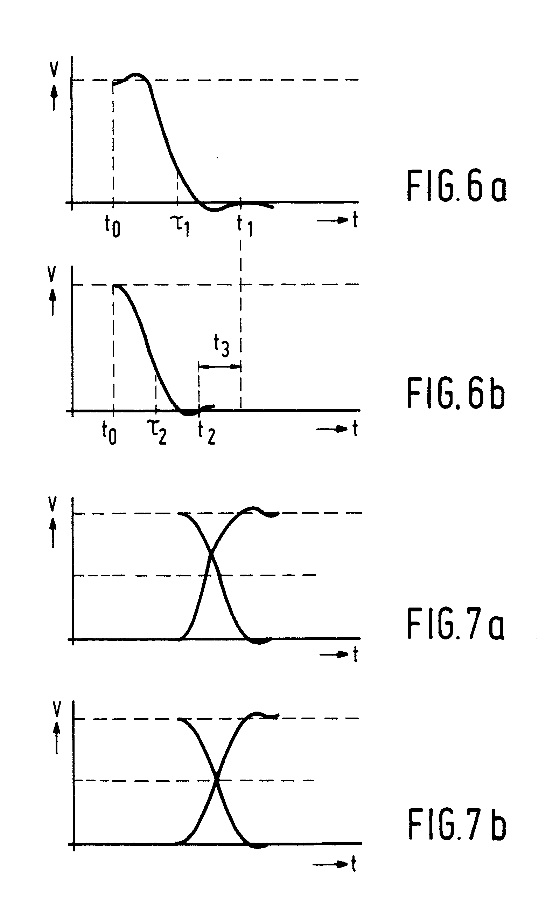

Il présente les points communs suivants avec l'antériorité US 3 564 281 (fig.7b). Un transistor $T_1$ à son collecteur chargé par une résistance $R_{11}$. Deux transistors $T_4$ et $T_6$ ont leurs trajets collecteur-émetteur en série comme les transistors Q et $Q_2$, le transistor $T_4$ ayant une résistance $R_{14}$ dans son collecteur. En outre, il existe une liaison entre la base du transistor $T_1$ et celle du transistor $T_6$.

Le circuit de la figure 2 diffère de celui de la fig.7b de l'antériorité US 3 564 281 par les points suivants :

- pour obtenir une commutation plus rapide favorable au fonctionnement désiré en signaux carrés, un condensateur $C_1$ est disposé en parallèle avec la résistance $R_{11}$, ce qui améliore de manière surprenante la réponse en transitoires (effet de compensation dynamique).
- pour que la commutation du transistor $T_4$, dont la base est connectée au collecteur du transistor $T_1$ et dont le trajet collecteur-émetteur est en série avec celui du transistor $T_6$, s'effectue en synchronisme avec celle du transistor $T_6$, une résistance $R_{16}$ est disposée en série dans la base de $T_6$. La résistance $R_{16}$ (de valeur déterminée expérimentalement en visualisant les signaux ) ralentit la commutation du transistor $T_6$ de manière à ce que celle-ci s'effectue sensiblement en synchronisme avec celle du transistor $T_1$ - (accélérée par $C_1$) et du transistor $T_4$. On obtient ainsi un minimum d'éléments et un trajet aussi court que possible pour les signaux, ce qui est favorable à la commutation de signaux carrés tels que ceux d'une horloge, plus particulièrement sur une charge essentiellement capacitive C.

Il est particulièrement avantageux que les signaux E sur la base du transistor $T_1$ aient un niveau bas tel que le transistors $T_1$ et $T_6$ ne se trouvent pas à l'état bloqué, et un niveau haut tel que les transistors $T_1$ et $T_6$ ne soit pas saturés. On est alors dans les meilleures conditions pour une commutation rapide.

Lorsque le signal d'entrée E est au niveau bas, $T_1$ est bloqué, (de préférence non entièrement), le transistor $T_4$ est ouvert et le transistor $T_6$ est bloqué (ou de préférence fonctionne à courant réduit). Le condensateur C se charge à travers le trajet collecteur-émetteur du transistor $T_4$. Une résistance $R_{14}$ peut être disposée dans le collecteur de $T_4$. Lorsque le signal d'entrée E est au niveau haut, $T_1$ est ouvert, le transistor $T_4$ est bloqué, (de préférence non entièrement), et le transistor $T_6$ est ouvert. Le condensateur C se décharge à travers le trajet collecteur-émetteur du transistor $T_6$. Une résistance $R'_6$ peut être connectée entre l'émetteur du transistor $T_6$ et le pole de mode commun. Un condensateur $C'_6$ dont la fonction sera explicitée dans la suite de la description peut être disposée en parallèle avec la résistance $R'_6$.

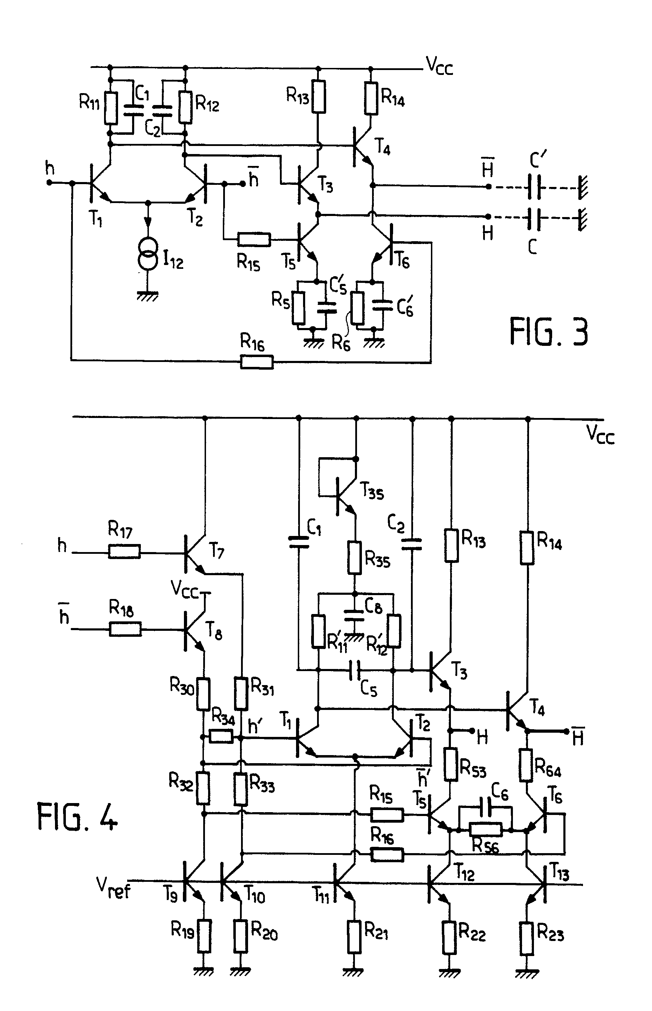

Selon la figure 3, un amplificateur différentiel selon l'invention comporte deux cellules selon la figure 2. Les éléments $T_1$, $T_4$, $T_6$, $R_{11}$, $R_{14}$, $R_{16}$, $R'_6$, $C_1$ et $C'_6$ de la première cellule sont dénommés respectivement $T_2$, $T_3$, $T_5$, $R_{12}$, $R_{13}$, $R_{15}$, $R'_5$, $C_2$ et $C'_5$ dans la deuxième cellule. Les transistors $T_1$ et $T_2$ sont couplés par les émetteurs pour former un étage différentiel, et une source de courant $I_{12}$ est connectée à ceux-ci. La base de $T_1$ reçoit un signal d'horloge h et celle de $T_2$, son inverse logique $\bar{h}$. La sortie H, en phase avec h au temps de réponse près, est l'émetteur du transistor $T_3$. La sortie $\bar{H}$, en phase avec $\bar{h}$ au temps de réponse près, est l'émetteur du transistor $T_4$. Les sorties H et $\bar{H}$ sont destinées à être chargées par des impédances essentiellement capacitives respectivement C et C'.

Selon la figure 4, les éléments communs avec la figure 3 portent la même référence. La source de courant $I_{12}$, est constituée par un transistor $T_{11}$, une résistance d'émetteur $R_{21}$, et la base de $T_{11}$ est alimentée à une tension de référence $V_{REF}$. Des sources de courant connectées aux émetteurs respectivement de $T_5$ et $T_6$ sont constitués par des transistors respectivement $T_{12}$ et $T_{13}$, présentant une résistance d'émetteur respectivement $R_{22}$ et $R_{23}$, et dont la base est alimentée à une tension de référence $V_{REF}$. Les dimensions des transistors $T_{11}$, $T_{12}$ et $T_{13}$ et les valeurs des résistances $R_{21}$, $R_{22}$ et $R_{23}$ permettent de déterminer les diverses valeurs de courant dans les collecteurs desdits transistors.

Le circuit de la figure 4 présente un certain nombre d'améliorations par rapport à celui de la figure 3, et pouvant être mise en oeuvre en combinaison ou séparément.

Tout d'abord les signaux d'horloge h et $\bar{h}$ sont appliqués à l'entrée de deux diviseurs de tension présentant des transistors respectivement $T_7$ et $T_8$ montés en émetteur suiveur (résistances de base respectivement $R_{17}$ et $R_{18}$). L'émetteur de $T_7$ est connecté à une première branche de division de tension comprenant en série deux résistances $R_{31}$ et $R_{33}$ et une source de courant ($T_{10}$, $R_{20}$, $V_{REF}$). L'émetteur de $T_8$ est connecté à une deuxième branche de division de tension comportant deux résistances $R_{30}$ et $R_{32}$ et une source de courant ($T_9$, $R_{19}$, $V_{REF}$). Le point commun aux résistances $R_{31}$ et $R_{33}$ est connecté à la base de $T_1$. Le point commun aux résistances $R_{30}$ et $R_{32}$ est connecté à la base de $T_2$. Le point commun à la résistance $R_{33}$ et à la source de courant ($T_{10}$, $R_{20}$, $V_{REF}$), à savoir le collecteur de $T_{10}$ alimente la base de $T_6$ à travers la résistance $R_{16}$. Le point commun à la résistance $R_{32}$ et à la source de courant ($T_9$, $R_{19}$, $V_{REF}$), à savoir le collecteur de $T_9$, alimente la base de $T_5$ à travers la résistance $R_{15}$.

Les deux points communs précités, connectés aux bases des transistors respectivement $T_1$ et $T_2$, sont reliés entre eux par une résistance $R_{34}$. Pour $R_{30}$ et $R_{21}$ de même valeur, on a (en désignant par h' et $\bar{h}'$ les tensions de base respectivement des transistors $T_1$ et $T_2$ :

$$h' - \bar{h}' = \frac{R_{34}}{R_{30}} \quad \frac{1}{1 + R_{34}/R_{30}} \quad (h - \bar{h})$$

Les résistances $R_{32}$ et $R_{33}$ servent à abaisser la tension si besoin est pour alimenter les bases de $T_5$ et $T_6$ et éviter la saturation de ces transistors. Leur valeur est à prendre en compte en série respectivement avec $R_{15}$ et $R_{16}$ pour le calcul du retard apporté par ces dernières résistances à la commutation de $T_5$ et $T_6$.

En variante, un diviseur à point de résistances peut être mis en oeuvre pour chacune des cellules.

Un condensateur $C_5$ disposé entre les collecteurs des transistors $T_1$ et $T_2$, permet d'éviter les pics de courant sur les collecteurs desdits transistors. Sa valeur est la plus faible possible compatible avec une atténuation satisfaisante des pics de courant (p. ex. 5 pF).

Les résistances $R_{11}$ et $R_{12}$ peuvent être reliées à la source de tension d'alimentation $V_{cc}$ avec décalage de tension produit par un transistor $T_{35}$ monté en diode. Sur la figure 4, on a représenté deux résistances $R'_{11}$ et $R_{12}$ ayant une borne interconnectée et en série avec une résistance $R_{35}$ et le transistor $T_{35}$ monté en diode. Un condensateur $C_8$ connecté entre le point d'interconnexion des résistances $R'_{11}$ et $R'_{12}$ et la masse (ou une deuxième source de tension d'alimentation) créé un effet de masse virtuel pour éliminer les effets de mode commun. $C_8$ peut avoir également une valeur faible (p. ex. 20 pF), mais de préférence suffisante pour compenser l'effet selfique de $T_{35}$. On peut choisir par exemple $R_{35} C_8 \simeq 10\, t_f$ ($t_f \simeq$ temps de montée de l'étage $T_1$, $T_2$), ce qui procure une correction pour les harmoniques.

Une résistance $R_{56}$ disposée entre les émetteurs de $T_5$ et $T_6$ a pour fonction de faire fonctionner les transistors $T_5$ et $T_6$ en étage différentiel dont la plage de linéarité peut être choisie en ajustant la valeur de $R_{56}$.

La commutation peut être ainsi réglée (linéarisation dynamique) pour que les transistors $T_5$ et $T_6$ voient alternativement passer un courant maximal ou minimal selon le signe instantané de la tension d'horloge. Pour fonctionner en mode linéaire, on doit avoir :

$$R_{56} \ I \geqq \Delta V + 4 \ V_T$$

    I :    intensité des sources de courant mettant en oeuvre les transistors $T_{12}$ et $T_{13}$.

    $\Delta V$ :    amplitude maximale des signaux sur les bases des transistors $T_5$ et $T_6$.

$V_T = 26$ mV.

On peut ajuster $R_{56} \ I$ pour avoir un rapport K entre les courants maximaux ou minimaux qui soit de l'ordre de 10.

Un condensateur $C_6$ en parallèle sur la résistance $R_{56}$ permet d'accélérer la commutation. En effet, le condensateur $C_6$ est vu comme une self sur les collecteurs des transistors $T_5$ et $T_6$.

Enfin des résistances $R_{53}$ et $R_{64}$ connectées respectivement entre l'émetteur de $T_3$ et le collecteur de $T_5$ d'une part, et l'émetteur de $T_4$ et le collecteur de $T_6$ d'autre part permettant de découpler les collecteurs de $T_5$ et $T_6$ des charges capacitives C et C', de manière à éviter les ondulations des signaux de sortie sur les niveaux haut ou bas. Leur valeur devra être aussi faible que possible pour obtenir l'effet désiré.

La figure 5 montre une variante de l'étage différentiel des transistors $T_5$ et $T_6$. Les émetteurs sont interconnectés par deux résistances en série $R'_{56}$ et $R''_{56}$ au point commun desquelles est connectée une source de courant ($T_{14}$, $R_{24}$, $V_{REF}$).

Les figures 6a et 6b illustrent l'influence du condensateur $C_1$ sur la commutation du transistor $T_1$. En l'absence du condensateur $C_1$, la réponse est entièrement stabilisée au temps $t_1$ - (correspondant à un temps de réponse $\tau_1$). Grâce au condensateur $C_1$, la réponse est plus rapide et se stabilise plus tôt, au temps $t_2$ (temps de réponse $\tau_2 < \tau_1$). D'où gain d'un temps $t_3$ pour obtenir une réponse entièrement stabilisée. La valeur du condensateur $C_1$ est ajustée expérimentalement de manière à obtenir le temps de réponse $\tau_2$ le plus court. On a ainsi pu obtenir un temps de réponse $\tau_2$ de quelques ns (p.ex. d'environ 2ns) avec un transistor d'un type donné en choisissant $R_{11} = 200\Omega$ et $C_1 = 2$pF, soit $R_{11}C_1 = 0,4$ns. Ceci correspond en l'espèce à une constante de temps inférieure au temps de réponse, valeur pouvant être optimisée en pratique.

Les figures 7a et 7b illustrent la fonction du condensateur $C'_6$ en parallèle avec la résistance $R'6$. Il s'agit de ramener la même impédance dans le collecteur du transistor $T_6$ et d'obtenir un fonctionnement symétrique de la cellule de la figure 2 sur des fronts ascendants et descendants, c'est-à-dire un entrecroisement au milieu de l'excurssion de tension.

Ce fonctionnement optimal est en général obtenu avec $R_{11}C_1 = R'_6C'_6$ (fig.7b) alors qu'à la fig.7a, est montré l'entrecroisement défectueux (et donc la symétrie défectueuse) en l'absence de compensation.

Nous allons maintenant donner des indications plus précises permettant de calculer les valeurs les plus favorables de certains au moins des composants.

Le réseau parallèle $R_{11} \ C_1$ est vu dans l'émetteur de T4 comme un self L' en série avec une résistance R'.

$$L' = \frac{\tau_n \ t_f^2}{\tau^2 \ \pi^2} \ R_{11}$$

$$R' \simeq \frac{\tau_n}{C_1}$$

avec

    $\tau$    $= R_{11} \ C_1$,

    $\tau_n$    $=$ temps de transit dans la base d'un transistor.

$t_f$: temps de montée du signal sur la base de $T_4$.

Le réseau parallèle $R'_6 \ C'_6$ dans le collecteur de $T_6$ est vu comme un self L" en série avec une résistance R'.

    L"    $= R_c \ R'_6 \ C'_6$

    R"    $= R_c$

avec $R_c$: résistance intrinsèque de collecteur de $T_6$ (en série avec $R_{64}$ le cas échéant).

Les transistors $T_4$ et $T_6$ sont dans les mêmes conditions de commutation si L' = L" et R' = R".

Si on choisit

$$\pi \ \frac{\tau}{t_f} \simeq 1,$$

on aura en première approximation :

$$R_c \ R'_6 \ C'_6 = \tau_n \ R_{11}$$

$$R_c \ C_1 = \tau_n$$

d'où :

$$R_{11} \ C_1 \ = \ R'_6 \ C'_6 \ \simeq \ \frac{t_f}{\pi}$$

Pour la figure 4 on aura :

$$R_{11} \ C_1 \ = \ R_{56} \ C_6 \ = \ \frac{t_f}{\pi}$$

En pratique on peut choisir pour $t_f$ le temps de montée du transistor $T_1$.
Exemple :
$R_{11}$ = 200Ω, $C_1$ = 2pF
$R_{56}$ = 600Ω, $C_6$ = 0,75pF.
En outre, il faut $R_{11} \ I_{12} > \Delta V$.
   Pour une décharge rapide de C, on choisira :

$$I_{12} \ = \ I_{13} \ \geqslant \ \frac{C\Delta V}{t}$$

t = temps de décharge souhaité pour le condensateur C.

## Revendications

1. Cellule d'amplificateur de puissance comprenant un amplificateur inverseur d'entrée comportant un premier transistor ayant un collecteur relié à une première source de tension d'alimentation à travers une première résistance, ainsi qu'un étage de sortie présentant un deuxième et un troisième transistor ayant des trajets collecteur-émetteur en série, leur point commun constituant une sortie de l'amplificateur de puissance, la base du deuxième transistor étant connectée au collecteur du premier transistor, et des moyens pour appliquer à la base du troisième transistor un signal de commande en phase avec un signal d'entrée appliqué à la base du premier transistor, caractérisé en ce qu'il comporte un premier condensateur ($C_1$) disposé en parallèle avec la première résistance ($R_{11}$), en ce que le signal de commande est le signal d'entrée (E) à un coefficient multiplicatif près inférieur ou égal à 1 et en ce que lesdits moyens consistent en une deuxième résistance ($R_{16}$) disposée en série dans la base du troisième transistor.

2. Cellule d'amplificateur selon la revendication 1, caractérisé en ce qu'il comporte un diviseur de tension agencée de manière à recevoir le signal d'une source d'entrée et à générer le signal d'entrée et le signal de commande.

3. Cellule d'amplificateur selon une des revendications 1 ou 2, caractérisé en ce que le produit des valeurs de la première résistance ($R_{11}$) et du premier condensateur ($C_1$) est inférieur au temps de montée ($\tau_2$) de ladite cellule.

4. Cellule d'amplificateur selon une des revendications 1 à 3, caractérisé en ce qu'elle comporte un réseau parallèle résistance-condensateur ($R'_6$, $C'_6$) disposé dans l'émetteur du troisième transistor.

5. Cellule d'amplificateur selon la revendication 4, caractérisé en ce que la constante de temps ($R'_6$, $C'_6$) dudit réseau parallèle est égale au produit des valeurs de la première résistance ($R_{11}$) et du premier condensateur ($C_1$).

6. Amplificateur différentiel de puissance comportant deux cellules d'amplificateur selon une des revendications 1 à 5, caractérisé en ce que les premiers transistors ($T_1$, $T_2$) de chaque cellule sont couplés entre eux par les émetteurs.

7. Amplificateur différentiel selon la revendication 6, caractérisé en ce que les troisième transistors ($T_5$, $T_6$) présentent une troisième résistance ($R_{56}$) connectée entre leurs émetteurs.

8. Amplificateur différentiel selon la revendication 7, caractérisé en ce qu'il comporte une première ($T_{12}$, $R_{22}$) et une deuxième ($T_{13}$, $R_{23}$) source de courant connectées à l'émetteur respectivement de chacun des troisième transistors ($T_5$, $T_6$).

9. Amplificateur différentiel selon la revendication 6, caractérisé en ce qu'il comporte une quatrième ($R'_{56}$) et une cinquième ($R''_{56}$) résistance connectées en série entre les émetteurs des troisièmes transistors et dont la somme des valeurs est égale à celle de la troisième résistance ($R_{56}$) ainsi qu'une troisième source de courant ($T_{14}$, $R_{24}$, $V_{REF}$) connectée au point commun à la quatrième ($R'_{56}$) et à la cinquième ($R''_{56}$) résistance.

10. Amplificateur différentiel selon une des revendications 7 à 9, caractérisé en ce qu'il comporte un troisième condensateur ($C_6$) entre les émetteurs desdits troisièmes transistors.

11. Amplificateur différentiel selon la revendication 10, caractérisé en ce que le produit des valeurs de la première résistance ($R_{11}$) et du

premier condensateur ($C_1$) est égal au produit des valeurs de la troisième résistance ($R_{56}$) et du troisième condensateur ($C_6$).

12. Amplificateur différentiel selon une des revendications 5 à 11, caractérisé en ce qu'il comporte une sixième ($R_{53}$) et une septième ($R_{64}$) résistance disposées en série respectivement entre les trajets collecteur-émetteur des deuxième ($T_5$) et troisième ($T_6$) transistors des deux cellules.

13. Amplificateur différentiel selon une des revendications 6 à 12, caractérisé en ce qu'il comporte une huitième résistance ($R_{34}$) connectée entre les bases des premiers transistors des deux cellules.

14. Amplificateur différentiel selon une des revendications 6 à 13, caractérisé en ce qu'il comporte un transistor monté en diode et en direct entre un point commun aux premières résistances ($R'_{11}$, $R'_{12}$) des deux cellules et la première source de tension d'alimentation ($V_{cc}$).

15. Amplificateur différentiel selon la revendication 14, caractérisé en ce qu'il comporte un quatrième condensateur ($C_8$) connecté entre ledit point commun aux premières résistances ($R'_{11}$, $R'_{12}$) et la deuxième source de tension d'alimentation.

FIG.1a

FIG.1b

FIG. 2

FIG. 5

FIG. 3

FIG. 4

FIG. 6 a

FIG. 6 b

FIG. 7 a

FIG. 7 b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IBM TECHNICAL DISCLOSURE BULLETIN. vol. 28, no. 10, mars 1986, NEW YORK US pages 4627 - 4628; "Improved Switching Circuit for Off-Chip Drivers " <br> * le document en entier * | 1,2 | H 03 K 17/66 <br> H 03 K 19/00 <br> H 03 F 3/30 |
| A | IBM TECHNICAL DISCLOSURE BULLETIN. vol. 22, no. 8A, janvier 1980, NEW YORK US page 3223 j.l. Dorler___ j.m. Mosley: "Complementary Emitter Follower Driver" <br> * le document en entier * | 1,4,5 | |
| A | IBM TECHNICAL DISCLOSURE BULLETIN. vol. 22, no. 12, mai 1980, NEW YORK US pages 5383 - 5384; R.R. Konian J.L. Walsh: "Bipolar Transistor Logic Driver with in-phase and out-of-phase outputs" <br> * le document en entier * | 1,4,5 | |
| A | EP-A-0 110 317   (CSELT S.P.A. IT) <br> * page 3, ligne 30 - page 6, ligne 4; figure 3 * | 1,6,8 | |
| A | RADIO FERNSEHEN ELEKTRONIK. vol. 36, no. 3, 1987, BERLIN DD page 196 "U-I-Wandler hoher Leistung für__ induktive Lasten " <br> * le document en entier * | 6-10 | DOMAINES TECHNIQUES RECHERCHES (Int. Cl.5) <br><br> H 03 F <br> H 03 K |

Le présent rapport de recherche a été établi pour toutes les revendications

| Lieu de la recherche | Date d'achèvement de la recherche | Examinateur |
|---|---|---|
| La Haye | 24 juin 91 | TYBERGHIEN G.M.P. |